Europäisches Patentamt

European Patent Office

Office européen des brevets

(11) Numéro de publication : **0 485 921 B1**

(12) **FASCICULE DE BREVET EUROPEEN**

(45) Date de publication du fascicule du brevet :
30.06.93 Bulletin 93/26

(51) Int. Cl.⁵ : **H04L 1/00, H03M 13/12**

(21) Numéro de dépôt : **91119174.0**

(22) Date de dépôt : **11.11.91**

(54) **Dispositif prévu pour le traitement de l'algorithme de Viterbi comprenant un processeur et un opérateur spécialisé.**

(30) Priorité : **15.11.90 FR 9014230**

(43) Date de publication de la demande :
**20.05.92 Bulletin 92/21**

(45) Mention de la délivrance du brevet :
**30.06.93 Bulletin 93/26**

(84) Etats contractants désignés :
**AT BE CH DE DK ES FR GB GR IT LI LU NL SE**

(56) Documents cités :
**EP-A- 0 210 932**
**IEEE TRANSACTIONS ON COMMUNICA-**
**TIONS vol. 38, no. 5, Mai 1990, NEW YORK, US**
**pages 578 - 583; ZHENHUA XIE ET AL: 'MUL-**
**TIUSER SIGNAL DETECTION USING SEQUEN-**
**TIAL DECODING'**
**TELECOMMUNICATIONS AND RADIO ENGI-**
**NEERING vol. 43, no. 8, Août 1988, NEW YORK,**
**US pages 24 - 29; V.L.BANKET ET AL: 'MULTI-**
**POSITION-SIGNAL CONVOLUTION CODECS**
**AND CODEMS'**

(73) Titulaire : **ALCATEL RADIOTELEPHONE**
**10, rue de la Baume**
**F-75008 Paris (FR)**

(72) Inventeur : **Desperben, Lydie**
**10, rue Charles Chefson**
**F-92270 Bois Colombes (FR)**
Inventeur : **Dartois, Luc**
**98, avenue Paul Denis Huet**
**F-78955 Carrieres sous Poissy (FR)**
Inventeur : **Rousseau, Emmanuel**
**22, rue Jean Mermoz**
**F-75008 Paris (FR)**

(74) Mandataire : **Weinmiller, Jürgen et al**
**Lennéstrasse 9 Postfach 24**
**W-8133 Feldafing (DE)**

Jouve, 18, rue Saint-Denis, 75001 PARIS

**Description**

La présente invention concerne un dispositif comprenant un processeur qui est prévu notamment pour effectuer le traitement de l'algorithme de Viterbi.

L'algorithme de Viterbi connu en traitement numérique du signal, est employé dans plusieurs domaines où il s'agit de faire l'estimation de la valeur des bits d'une suite numérique. Parmi ces domaines figurent, entre autres, le décodage convolutionnel et l'égalisation en démodulation numérique.

Cet algorithme peut être mis en oeuvre au moyen d'un processeur de traitement de signal numérique de type généraliste. Un tel processeur n'est pas particulièrement prévu pour le traitement de cet algorithme et nécessite, pour ce faire, un très grand nombre d'instructions. Le temps de traitement, lié au nombre d'instructions à effectuer, est donc important.

Il est par ailleurs courant, dans un circuit de traitement du signal, qu'il soit nécessaire d'effectuer des traitements supplémentaires.

Une première solution consiste à prévoir le processeur de traitement du signal avec une puissance permettant d'effectuer le traitement de l'algorithme de Viterbi et ces traitements supplémentaires. A supposer qu'un processeur doté d'une telle puissance soit disponible, il sera nécessairement assez coûteux.

Une deuxième solution consiste à confier le traitement de l'algorithme de Viterbi à un composant spécifiquement prévu à cet usage, le processeur de Viterbi commercialisé par FUJITSU sous la référence MB 86620, par exemple. Dans ce cas, le circuit de traitement du signal nécessite au moins deux composants, sa taille est donc plus importante et son prix plus élevé. De plus il se prête mal à une miniaturisation, indispensable dans certaines applications.

La présente invention a ainsi pour objet un dispositif prévu notamment pour le traitement de l'algorithme de Viterbi, ce dispositif n'employant pas de composant spécialisé mais un processeur de signal de type généraliste pour lequel la puissance nécessaire à ce traitement a été réduite. Ce dispositif est également conçu pour être intégré dans un seul composant.

Le dispositif selon l'invention comprend un processeur et est prévu pour le traitement de l'algorithme de Viterbi, cet algorithme étant défini par sa longueur de contrainte de valeur $n+1$ et ses $2^n$ états associés à des suites de bits, le traitement ayant pour objet l'estimation d'une suite initiale de bits $b(i)$, à partir d'une suite transmise résultant d'une opération de transmission effectuée sur la suite initiale. Il comprend de plus un opérateur pour établir la métrique maximale au rang r de l'état $E_j$ dénommée $Met_r(E_j)$, pour r supérieur à n, et le $(r-n)$ième bit de la suite correspondant à cette métrique, à partir de valeurs d'entrées que sont les métriques maximales au rang $r-1$ des états $E_{2k}$ et $E_{2k+1}$ notées $Met_{r-1}(E_{2k})$ et $Met_{r-1}(E_{2k+1})$, et les probabilités conditionnelles en rapport auxdits états $E_{2k}$, $E_{2k+1}$ que le rième bit des suites associées à ces états ait une valeur déterminée dénommées $Pr(b(r)=O/E_{2k})$ et $Pr(b(r)=O/E_{2k+1})$ par exemple, k étant égal à 2j pour tout j inférieur à $2^{n-1}$ et valant $2(j-2^{n-1})$ pour tout j supérieur ou égal à $2^{n-1}$, de sorte que $Met_r(E_j)$ prenne la valeur de la plus grande des deux expressions suivantes, la première étant $Met_{r-1}(E_{2K})+Pr(b(r)=O/E_{2k})$ et la seconde étant $Met_{r-1}(E_{2k+1}) + Pr(b(r)=O/E_{2k+1})$.

L'opérateur décharge ainsi le processeur de certaines opérations qui sont effectuées un très grand nombre de fois avec des moyens relativement simples.

De plus dans le dispositif prévu pour le traitement de l'algorithme de Viterbi comprenant un processeur, l'opérateur comprend des moyens additionnels pour établir quel que soit j inférieur à $2^{n-1}$ à partir des valeurs d'entrée non seulement la métrique maximale au rang r de l'état $E_j$ $Met_r(E_j)$ et le $(r-n)$ième bit correspondant, mais également la métrique maximale au rang r de l'état $E_{j+a}$ $Met_r(E_{j+a})$ et le $(r-n)$ième bit correspondant où a vaut $2^{n-1}$, de sorte que $Met_r(E_{j+a})$ prenne la valeur de la plus grande des deux formules suivantes, la première étant $Met_{r-1}(E_{2j}) - Pr(b(r)=O/E_{2j})$ et la seconde étant $Met_{r-1}(E_{2j+1}) - Pr(b(r)=O/E_{2j+1})$.

Dans un premier mode de réalisation du dispositif prévu pour le traitement de l'algorithme de Viterbi comprenant un processeur, l'opérateur étant relié au processeur par au moins un bus de données et un bus de commande, il comprend quatre registres d'entrée dont les entrées sont connectées chacune à l'un des bus de données, le premier étant prévu pour recevoir la valeur de $Met_{r-1}(E_{2j})$, le second la valeur de $Pr(b(i)=O/E_{2j})$, le troisième la valeur de $Met_{r-1}(E_{2j+1})$ et le quatrième la valeur de $Pr(b(i)=O/E_{2j+1})$, il comprend également un premier et un deuxième circuit de calcul prévus pour produire respectivement un premier et un deuxième résultat prenant la valeur en réponse à un signal de commande de la somme ou de la différence des contenus respectivement des deux premiers registres d'entrées et des deux derniers registres d'entrée, il comprend un comparateur délivrant un signal de sortie de valeur 1 lorsque ledit premier résultat est inférieur audit deuxième résultat et de valeur 0 dans le cas contraire, un multiplexeur commandé par le comparateur produisant comme signal de sortie celui des résultats qui présente la plus forte valeur, il comprend de plus trois registres de sortie dont les sorties sont raccordées chacune à l'un des bus de données, le premier et le deuxième recevant le signal de sortie du multiplexeur et étant prévus pour enregistrer les valeurs de respectivement $Met_r(E_j)$ et

$Met_r(E_{j+a})$, le troisième recevant le signal de sortie du comparateur qui est le (r-n)ième bit des suites correspondant à ces métriques, et il comprend un module de commande prévu pour commander ses différents éléments en fonction des informations adressées par le processeur sur le bus de commande.

De plus, dans le dispositif prévu pour le traitement de l'algorithme de Viterbi comprenant un processeur, le troisième registre de sortie est prévu pour enregistrer le (r-n)ième bit de toutes les suites correspondant aux $2^n$ métriques maximales à un rang déterminé.

En outre, dans le dispositif prévu pour le traitement de l'algorithme de Viterbi, comprenant un processeur, ce processeur comprenant deux bus de données, les premier et troisième registres d'entrée ont leur entrée connectée au premier des bus de données, les deuxième et quatrième registres d'entrée ont leur entrée connectée au second bus de données, tandis que lesdits premier et second registres de sortie ont leur sortie connectée chacune à un bus de donnée distinct.

De manière avantageuse, dans le dispositif prévu pour le traitement de l'algorithme de Viterbi comprenant un processeur, l'opérateur comprend des moyens supplémentaires pour établir les probabilités conditionnelles en rapport aux états $E_{2k}$, $E_{2k+1}$ que les rièmes bits des suites associées à ces états ait un état déterminé en fonction des pondérations des bits de la suite transmise liés à ces rièmes bits, du nombre k associé aux états $E_{2k}$, $E_{2k+1}$ et des relations définissant l'opération de transmission.

Ainsi, l'opérateur, s'il comprend plus d'éléments, décharge également le processeur de ces calculs afin de diminuer encore le temps qu'il consacre à ce traitement.

Dans un deuxième mode de réalisation du dispositif prévu pour le traitement de l'algorithme de Viterbi comprenant un processeur, l'opérateur étant relié au processeur par au moins un bus de données et un bus de commande, il comprend des registres de transfert dont les entrées sont reliées chacune à l'un des bus de données, ces registres de transfert étant prévus pour mémoriser chacun une des pondérations, et une unité arithmétique câblée connectée aux sorties des registres de transfert, ayant accès à la valeur j identifiant un état, et établissant les relations définissant l'opération de transmission pour produire les probabilités conditionnelles, il comprend quatre registres d'entrée, le premier dont l'entrée est raccordée à l'un des bus de données étant prévu pour recevoir la valeur de $Met_{r-1}(E_{2j})$, le second mémorisant la valeur de $Pr(b(r)=O/E_{2j})$ fournie par l'unité arithmétique, le troisième dont l'entrée est raccordée à l'un des bus de données étant prévu pour recevoir la valeur de $Met_{r-1}(E_{2j+1})$ et le quatrième mémorisant la valeur de $Pr(b(r)=O/E_{2j+1})$ fournie par l'unité arithmétique, il comprend également un premier et un deuxième circuit de calcul prévus pour produire respectivement un premier et un deuxième résultat prenant la valeur en réponse à un signal de commande de la somme ou de la différence des contenus respectivement des deux premiers registres d'entrée et des deux derniers registres d'entrée, il comprend un comparateur délivrant un signal de sortie de valeur 1 lorsque le premier résultat est inférieur au deuxième résultat et de valeur 0 dans le cas contraire, et un multiplexeur commandé par le comparateur produisant comme signal de sortie celui des résultats qui présente la plus forte valeur, il comprend de plus trois registres de sortie dont les sorties sont raccordées chacune à l'un des bus de données, le premier et le deuxième recevant le signal de sortie du multiplexeur et étant prévus pour enregistrer les valeurs de respectivement $Met_r(Ej)$ et $Met_r(E_{j+a})$, le troisième recevant le signal de sortie dudit comparateur qui est le (r-n)ième bit des suites correspondant à ces métriques, et il comprend un module de commande prévu pour commander ses différentes éléments en fonction des informations adressées par le processeur sur le bus de commande.

De plus, dans le dispositif prévu pour le traitement de l'algorithme de Viterbi comprenant un processeur, le troisième registre de sortie est prévu pour enregistrer le (r-n)ième bits de toutes les suites correspondant aux $2^n$ métriques maximales à un rang déterminé.

En outre, dans le dispositif prévu pour le traitement de l'algorithme de Viterbi comprenant un processeur, le processeur comprenant deux bus de données, les registres de transfert ont leurs entrées réparties sur le premier et sur le second bus de données, le premier et le troisième registres d'entrées ont leurs entrées reliées chacune à un bus de données distinct, tandis que les premier et second registres de sortie ont leur sortie connectée chacune à un bus de données distinct.

Quel que soit le mode de réalisation adopté, on peut prévoir dans le dispositif prévu pour le traitement de l'algorithme de Viterbi comprenant un processeur, que certains des éléments de l'opérateur soient implantés dans le processeur.

Une première application du dispositif prévu pour le traitement de l'algorithme de Viterbi comprenant un processeur consiste, l'opération de transmission étant un codage convolutionnel, à effectuer le décodage de la suite transmise.

Une deuxième application du dispositif prévu pour le traitement de l'algorithme de Viterbi comprenant un processeur consiste, l'opération de transmission introduisant une interférence intersymbole dans la suite transmise, à effectuer l'égalisation de cette suite.

Les différents objets et caractéristiques de la présente invention apparaîtront maintenant plus précisément dans le cadre de la description d'exemples de réalisation donnés à titre non limitatif en se référant aux figures annexées qui représentent :

- la figure 1, le schéma d'un circuit correspondant à un premier mode de réalisation de l'invention,
- la figure 2, le schéma d'un autre circuit correspondant à un deuxième mode de réalisation de l'invention.

Les éléments communs aux deux figures seront affectés d'une seule référence.

L'algorithme de Viterbi apporte une solution au problème de l'estimation d'une suite initiale à partir d'une suite transmise. La suite transmise est obtenue après modification de la suite initiale par un milieu de transmission, par un codage ou par tout autre moyen dont l'effet est connu. On adoptera le terme générique d'opération de transmission pour qualifier ces modifications. L'estimation se fait par le calcul des probabilités, pour chaque suite initiale, que celle-ci produise la suite transmise. La suite initiale solution est celle qui présente la plus forte probabilité.

L'algorithme de Viterbi sera maintenant exposé de manière à introduire les grandeurs qui font l'objet d'un traitement dans l'invention.

Les grandeurs d'entrée sont :

- L'ensemble des $L_t$ probabilités caractérisant la suite transmise de longueur $L_t$, chacune de ces probabilités caractérisant la valeur d'un bit de la suite transmise BT (i), où i prend toutes les valeurs comprises entre 1 et $L_t$,
- Les paramètres caractérisant l'environnement dans lequel s'est effectué l'opération de transmission.

Dans l'algorithme, on utilise plus généralement la notion de pondération, ceci pour des raisons de normalisation des calculs. La pondération est définie par rapport à la probabilité de valeur d'un bit comme l'indique la formulation ci-dessous :

$$\text{Pond (BT (i))} = \llbracket 2.\text{Probabilité (BT (i)=1)}-1 \rrbracket.\text{Pondmax}$$
$$\llbracket 1-2.\text{Probabilité (BT (i)=0)} \rrbracket.\text{Pondmax}$$

On considère donc que l'on a en entrée la suite des $L_t$ pondérations correspondant aux $L_t$ probabilités de valeur des bits de la suite transmise, chacune de ces pondérations pouvant varier entre pondmax et -pondmax. Les paramètres caractérisant l'environnement dans lequel s'est effectués la transmission permettent de définir la relation existant entre les bits de la suite initiale et les bits de la suite transmise. Ils permettent donc de définir une redondance éventuelle qu'introduit la transmission. On considère donc que la longueur de la suite transmise $L_t$ vérifie :

$L_t$ = L.T, L étant la longueur de la suite initiale, et T l'ordre de redondance.

Plus précisément, ces paramètres définissent les relations entre un bit BT(i) de la suite transmise, et les n+1 bits b(i) de la suite initiale dont il dépend. Il y a donc T relations qui peuvent s'exprimer par :

$$\text{BT (i.T)} = F_1[b (i), b (i - 1), b(i - n)]$$
$$\text{BT (i.T + 1)} = F_2[b (i), b(i - 1), b(i - n)]$$
$$\text{BT (i.T + T - 1)} = F_T[(b(i), b (i - 1), b (i - n)]$$

Par exemple :

- le codage convolutionnel de taux 1/T introduit une redondance d'ordre T et décrit T relations entre les bits transmis et ceux à transmettre.
- la transmission d'un signal numérique sur des voies affectées d'interférence intersymbole n'introduit pas de redondance et ne définit qu'une seule relation (T=1 et donc $L_t$ =L). Les grandeurs d'entrée permettent d'obtenir en sortie de l'algorithme de Viterbi la suite des L bits correspondant au maximum de vraisemblance d'être la suite initiale correspondant à la suite transmise.

L'application directe de la règle du maximum de vraisemblance voudrait que l'on calcule, pour une suite de longueur L, les $2^L$ probabilités pour les $2^L$ suites possibles, ce qui nécessiterait un temps considérable au vu des ordres de grandeur de L. L'algorithme de Viterbi va permettre de résoudre le problème en réduisant fortement le nombre de calculs de probabilités. Cette réduction est obtenue par l'estimation progressive (bit par bit) des suites les plus probables en prenant en compte les relations liant chaque bit transmis et les n+1 bits à transmettre correspondants pour le calcul des probabilités de vraisemblance des suites.

A partir de ces T relations, on définit T nouvelles relations qui décrivent T expressions de la probabilité que le bit b(i) de la suite initiale soit égal à X, symbole binaire, connaissant ses n bits antécédents et la pondération des bits transmis :

4

$$Pr_1 \ (b \ (i) = X) = G_1 \ [Pond \ (BT(i.T), \ X, \ b(i-1),\ldots\ldots,b(i-n)]$$

$$Pr_2 \ (b(i) = X) = G_2 \ [Pond \ (BT \ (i.T+1), \ X, \ b(i-1),\ldots,b(i-n)]$$

$$\ldots\ldots\ldots\ldots\ldots\ldots\ldots\ldots\ldots\ldots\ldots\ldots\ldots\ldots\ldots\ldots\ldots\ldots$$

$$Pr_T \ (b(i) = x) = G_T \ [Pond \ (BT(i.T+T-1), \ X, \ b(i-1),\ldots,b(i-n)]$$

Il est délicat de donner une description générale du passage des fonctions $F_m$ aux fonctions $G_m$ (m=1 à T) car ces relations dépendent uniquement de l'opération de transmission. Néanmoins, la connaissance des fonctions $F_m$ et de la pondération des bits transmis entraîne implicitement celle des fonctions $G_m$.

Des exemples concrets sont décrits par la suite.

Les fonctions $G_m$ définissent une expression des probabilités de valeur de b(i) qui vérifie :

$$Pr_m \ (b(i) = X) = [2.Proba \ (b(i)=X)-1]*Gmax$$
$$= [1-2.Proba \ (b(i)=1-X)]*Gmax$$

donc :

$$Pr_m \ (bit(i) = X) = Pr_m \ (bit(i) = 1 - X)$$

On définit alors une expression de la probabilité totale de la valeur de b(i) par :

$$Pr \ (b(i)=X) = (1/T). \sum_{m=1}^{T} Pr_m \ (b(i)=X)$$

Cette expression correspond donc à la probabilité conditionnelle de valeur de b(i) connaissant les n bits antécédents à b(i). On prend comme notation : Pr (b(i)=X/n).

On définit ensuite la métrique de la suite à estimer formée des L symboles binaires $X_i$ par :

$$Met \ (suite) = \sum_{i=1}^{L} Pr \ (b(i)=X_i/n) \qquad (1)$$

- Pour les n premiers bits de la suite initiale :

Ces bits forment une sous-suite numérique de la suite à estimer de longeur n. On effectue alors le calcul des $2^n$ métriques des $2^n$ suites possibles selon la formule (1).

- Pour le bit suivant :

Il y a $2^{n+1}$ suites possibles, on réduit ce chiffre aux $2^n$ suites les plus probables par élimination de suites éronnées suivant le critère de la vraisemblance maximale de ces suites, donc de la plus forte métrique, en se servant des calculs des métriques précedentes par récurrence.

On choisit la suite de n+1 bits qui a la plus forte métrique entre les deux suites binaires suivantes où les bits $b_i$(i=2 à n+1) sont figés :

$$S0: 0, b_2, b_3,...., b_n, b_{n+1}$$
$$S1: 1, b_2, b_3,...., b_n, b_{n+1}$$

Pour effectuer ce choix, il faut calculer les deux métriques des deux suites S0 et S1, Met (S0) et Met (S1), par la formule de récurence suivante :

$$Met \ (S0) = Met \ (0,b_2,b_3,....,b_n)t + Pr(bit(n+1) = b_{n+1}/n)$$
$$Met \ (S1) = Met \ (1,b_2,b_3,....,bn)t + Pr(bit(n+1) = b_{n+1}/n)$$

On connaît les métriques situées à droite de l'égalité par les calculs précédents. Il reste donc à calculer Pr(b(n+1)=$b_{n+1}$/n) qui représente une expression de la probabilité conditionnelle de $b_{n+1}$ connaissant la valeur des n bits précédents.

On garde alors en mémoire la suite de métrique maximale, sa métrique associée, et le choix du premier bit de la suite de métrique maximale.

Il y a $2^n$ couples de suites S0 et S1 possibles. On effectue donc ce processus $2^n$ fois et on voit donc que l'on a calculé les $2^n$ métriques correspondant aux $2^n$ suites les plus probables parmi les $2^{n+1}$ proposées en

effectuant des choix sur la valeur du premier bit de chacune de ces suites.

Ces choix correspondent à la probabilité maximale de vraisemblance du premier bit dans les suites. On a donc fixé les valeurs des premiers bits des $2^n$ suites présélectionnées formées de n+1 bits.

- Pour les bits suivants

Pour le bit suivant (qui correspond au $n+2^{\text{ième}}$), on effectue le même processus que celui décrit dans le paragraphe précédent qui va permettre d'estimer les $2^n$ suites les plus probables parmi les $2^{n+}$ suites formées des n+2 premiers bits.

En effet, il y a au total $2^{n+1}$ suites possibles formées par les n+2 premiers bits, car on prend en compte les choix du premier bit sur ces suites qui ont été fait précédemment. On a donc seulement n+1 bits variables sur ces suites, donc $2^{n+1}$ combinaisons possibles.

On va, comme précédemment, estimer les $2^n$ suites les plus probables parmi les $2^{n+1}$ proposées, en fixant le deuxième bit des $2^{n+1}$ suites possibles :

On choisit la suite de n+2 bits qui a la plus forte métrique entre les deux suites binaires suivantes où les bits $b_i$(i=3 à n+2) sont figés ainsi que les bits $B1_{so}$, et $B1_{s1}$, qui sont les premiers bits choisis précédemment :

$$S0' : B1_{so},0,b_3,....,b_{n+1},b_{n+2}$$
$$S1' : B1_{s1},1,b_3,....,b_{n+1},b_{n+2}$$

On calcule alors les deux métriques des deux suites S0' et S1', Met (S0') et Met (S1'), par la formule de récurence suivante avec les deux suites $S0''_1$, $S1''_1$, caractérisant les n bits antécédents et avec les probabilités conditionnelles liées à ces suites :

$$S0'' : 0, b_3,...,b_{n+1}$$
$$S1'' : 1, b_3,...,b_{n+1}$$
$$\text{Met (S0')} = \text{Met (B1}_{so}, 0,b_3,....,b_{n+1}) + Pr (b(n+2) = b_{n+2}/S0'')$$
$$\text{Met (S1')} = \text{Met (B1}_{s1}, 1, b_3,...,b_{n+1}) + Pr (b(n+2) = b_{n+2}/S1'')$$

On connaît les métriques situées à droite de l'égalité par les calculs précédents, il ne reste donc qu'à calculer les probabilités conditionnelles.

On garde alors en mémoire la suite de métrique maximale, sa métrique associée, et le choix du premier bit de la suite de métrique maximale.

On effectue donc ce processus $2^n$ fois pour les $2^n$ suites possibles S0' et S1' et on voit, comme précédemment, que l'on a calculé les $2^n$ suites les plus probables parmis les $2^{n+1}$ proposées, en effectuant des choix sur la valeur du second bit des $2^{n+1}$ suites, ces choix correspondant à la probabilité maximale de vraisemblance du bit dans la suite.

Pour les bits suivants (de rang n+3 à L), on va effectuer le même processus qui va permettre de choisir les $2^n$ suites les plus probables en choisissant, l'un après l'autre, les L-n premiers bits des $2^n$ suites suivant la vraisemblance maximale de ceux-ci.

A la fin de l'algorithme, on choisit alors la suite solution qui correspond à celle possédant la plus forte vraisemblance, c'est à dire la plus forte métrique, parmis les $2^n$ suites proposées.

On définira maintenant des variables qui seront utiles par la suite.

La longueur de contrainte est égale à n+1 et définit le nombre de bits consécutifs à transmettre reliés par les relations traduisant l'opération de transmission.

Un état de l'algorithme définit une suite possible de longueur 1 supérieure à n, ne possédant que ses n derniers bits variables. Chaque état $E_j$ caractérise donc une suite $S_j$ possible de n bits et peut être représentée par le nombre j :

$$S_j : b_{1-n+1}, b_{1-n+2},....,b_1$$

$$j = \sum_{i=0}^{n-1} b_{1-i} \cdot 2^{n-1-i}$$

Dans une formulation plus générale de l'algorithme de Viterbi, il s'agit de choisir l'une des deux suites suivantes $S0_j$, $S1_j$ où les bits $BS0_j$ (i) et $BS1_j$(i) (i=1 à r-n-1) ont été fixés par les étapes précédentes et où r représente un rang :

$$S0_j : BS0_j (1), BS0_j (2),....,BS0_j (r-n-1),0,b_{r-n+1}...,b_{r-1},b_r$$
$$S1_j : BS1_j (1), BS1_j (2),....,BS1_j (r-n-1),1,b_{r-n+1}...,b_{r-1},b_r$$

Ces deux suites binaires de longueur r correspondent au même état $E_j$ car elles possèdent les mêmes n derniers bits; par convention, les métriques qui leur sont associées sont dites de rang r et notées $Met_r$.

On calcule alors, pour chaque j (j=0..$2^n$-1), les deux métriques au rang r, $Met_r$ ($S0_j$) et $Met_r$ ($S1_j$) des deux

suites $S0_j$ et $S1_j$, et on choisit comme suite la plus probable celle qui a la plus forte métrique :

$$Met_r (S0_j) = Met_{r-1} (S0'_j) + Pr (b(r) = b_r/S0''_j)$$
$$Met_r (S1_j) = Met_{r-1} (S1'_j) + Pr (b(r) = b_r/S1''_j)$$

avec :

$$S0'_j : BS0_j (1), BS0_j, (2),...,BS0_j (r - n - 1), 0, b_{r-n+1},...,b_{r-1}$$
$$S1'_j : BS1_j (1), BS1_j (2),....,BS1_j(r - n - 1), 1, b_{r-n+1},...,b_{r-1}$$
$$S0''_j : 0, b_{r-n+1}...,b_{r-1}$$
$$S1''_j : 1, b_{r-n+1}...,b_{r-1}$$

En reprenant la définition d'un état d'une suite donnée précédemment et en introduisant le nombre $c = b_r.2^n$, on voit que les suites $S0'_j$ et $S1'_j$ correspondent respectivement aux états $E_{2j-c}$ et $E_{2j+1-c}$ des suites retenues lors de l'étape précédente dont les derniers bits forment respectivement les suites $S0''_j$ et $S1''_j$.

On peut alors définir une nouvelle formulation équivalente à la précédente en remplaçant l'identification d'une suite par l'état qui lui est associé où $Met_r(S0_j)$ et $Met_r(S1_j)$ sont respectivement notées $Met0_r(E_j)$ et $Met1_r(E_j)$ :

$$Met0_r(E_j) = Met_{r-1} (E_{2j-c}) + P_r (b(r) = b_r/E_{2j-c})$$
$$Met1_r(Ej) = Met_{r-1} (E_{2j+1-c}) + P_r (b(r) = b_r/E_{2j+1-c})$$

On définit alors la métrique maximale au rang r de l'état $E_j$ de la suite par la relation suivante où MAX [A,B] représente la plus grande des deux valeurs A, B :

$$Met_r (E_j) = MAX [Met1_r (E_j), Met0_r (E_j)]$$

On choisit te (r-n)ième bit des $2^n$ suites solutions suivant la métrique maximale.

On voit donc que le processus revient à calculer les $2^n$ métriques maximales, au rang r, des états $E_j$ (j = 0,...,$2^n$-1) des $2^n$ suites de r bits les plus probables à partir des $2^n$ métriques maximales au rang r-1 des $2^n$ états des suites de r-1 bits les probables calculées précédemment.

Considérons maintenant deux états particuliers $E_j$, $E_{j+a}$ pour j inférieur à $2^{n-1}$ qui correspondent à deux suites de bits différant uniquement par leur dernier bit, c'est-à-dire lorsque $a = 2^{n-1}$ :

$$E_j = b_{r-n+1}, b_{r-n+2},...,b_{r-2}, b_{r-1}, 0$$
$$E_{j+a} = b_{r-n+1}, b_{r-n+2},...,B_{r-2}, b_{r-1}, 1$$

Pour les métriques associées à l'état Ej, le nombre c précédemment défini est nul puisque son dernier bit $b_r$ est nul. On peut donc reformuler les métriques au rang r associée à l'état $E_j$ :

$$Met0_r (Ej) = Met_{r-1} (E_{2j}) + Pr (b(r) = 0/E_{2j})$$
$$Met1_r (Ej) = Met_{r-1} (E_{2j+1}) + Pr (b(r) = 0/E_{2j+1})$$

Pour les métriques associées à l'état $E_{j+a}$, le nombre c précédemment défini vaut $2^n$ puisque son dernier bit br vaut 1. Compte-tenu du fait que $P_r (b(r) = 1/E_j)$ et $P_r (b(r) = 0/E_j)$ sont de même valeur absolue et de signes opposés, on peut reformuler les métriques au rang r associés à l'état $E_{j+a}$ :

$$c = 2a$$
$$2(j + a) - c = 2j$$
$$2 (j + a) + 1 - c = 2j + 1$$
$$Met0_r (E_{j+a}) = Met_{r-1} (E_{2j}) - P_r (b(r) = 0/E_{2j})$$
$$Met1_r (E_{j+a}) = Met_{r-1} (E_{2j+1}) - P_r (b(r) = 0/E_{2j+1})$$

Il s'ensuit que les métriques maximales au rang r associées aux états $E_j$, $E_{j+a}$ peuvent être calculées au moyen des métriques maximales au rang r-1 associées aux états $E_{2j}$, $E_{2j+1}$ et des expressions des probabilités conditionnelles du rième bit b(r) relatives à ces deux derniers états.

L'invention propose une solution pour effectuer ces calculs en employant, dans un dispositif, un opérateur spécialisé couplé à un processeur de traitement numérique du signal. Elle s'applique à fortiori si seule la métrique maximale au rang r associée à l'état $E_j$ est calculée, moyennant quelques modifications à la portée de l'homme de l'art.

Le traitement de l'algorithme de Viterbi peut se décomposer en trois phases, une phase initiale, une phase récurrente et une phase finale.

La phase initiale consiste à établir les métriques maximales de rang n $Met_n(E_j)$.

Selon une technique connue, ces métriques sont calculées à partir de n bits de garde connus transmis avant la suite initiale. S'il n'est pas prévu de bits de garde, ces métriques sont calculées directement à partir des pondérations des bits transmis au lieu d'utiliser les probabilités conditionnelles des bits de la suite initiale.

La phase de récurrence sur laquelle porte plus précisément l'invention sera décrite plus loin. C'est elle qui nécessite le plus d'opérations et donc celle qui prend le plus de temps.

La phase finale consiste à définir la suite initiale la plus probable à partir des métriques maximales au rang L calculées lors de la phase précédente. Tout comme la phase initiale, elle est connue de l'homme de l'art.

La phase de récurrence sera donc maintenant décrite. Elle consiste à établir les métriques maximales au rang L à partir des métriques maximales au rang n.

Elle peut se présenter sous la forme d'une première boucle où l'indice i du bit b(i) de la suite initiale prend toutes les valeurs de n+1 à L, cette première boucle comprenant une deuxième boucle dans laquelle c'est l'indice j associé aux états $E_j$ de l'algorithme qui est incrémenté pour prendre toutes les valeurs entre 0 et $2^{n-1}$.

On note ch(i,j) la valeur du (i-n)ième bit de la jième suite associée à l'état $E_j$. Il vaut 1 si Met $1_i(E_j)$ est supérieur à Met $0_i(E_j)$ et 0 le cas contraire.

Boucle 1 : pour i=n+1 à L faire :

    initialisation

    Boucle 2 : pour j=0 à $2^{n-1}-1$ faire :

    $Met0_i (E_j) = Met_{i-1} (E_{2j}) + Pr(b(i)=0/E_{2j})$

    $Met1_i (E_j) = Met_{i-1} (E_{2j+1}) + Pr(b(i)= 0/E_{2j+1})$

    $Met_i(E_j) = MAX [Met1_i (E_j), Met0_i (E_j)]$

    ch (i,j) = (i-n)ième bit de la jième suite correspondant à $Met_i(E_j)$

    $Met0_i(E_{j+a}) = Met_{i-1} (E_{2j}) - Pr (b(i) = 0/E_{2j})$

    $Met1_i(E_{j+a}) = Met_{i-1} (E_{2j+1}) - Pr(b(i) = 0/E_{2j+1})$

    $Met_i (E_{j+a}) = Max [Met1_i(E_j), Met0_i(E_j)]$

    ch (i, j +a) = (i-n)ième bit de la (j+a)ième suite correspondant à $Met_i(E_{j+a})$

    Fin boucle 2.

    Mise à jour

Fin boucle 1

Les étapes "initialisation" et "mise à jour" sont mentionnées pour mémoire. Elle sont connues de l'homme de l'art et permettent notamment d'agencer de manière optimale la mémoire associée au processeur.

Dans un premier mode de réalisation de l'invention, l'opérateur effectue toutes les opérations de la deuxième boucle, hormis les calculs de probabilités conditionnelles qui sont effectués par le processeur.

L'opérateur reçoit en entrée, pour chaque itération de la deuxième boucle :

    $Met_{i-1} (E_{2j})$

    $Pr (b(i)=0/E_{2j})$

    $Met_{i-1}(E_{2j+1})$

    $Pr(b(i)=0/E_{2j+1})$

L'opérateur fournit en sortie pour chaque itération de la deuxième boucle.

    $Met_i(E_j)$

    $Met_i(E_{j+a})$

L'opérateur fournit en sortie pour chaque itération de la première boucle :

    ch(i,j) pour j=0 à $2^n-1$

On peut considérer que l'opérateur n'a pas besoin de connaître la valeur de j, en supposant que l'on initialise j à 0 à l'extérieur de la deuxième boucle dans l'étape d'initialisation de la première boucle, la valeur de j s'incrémentant automatiquement à chaque itération de la boucle.

De plus, on considère que les valeurs des (i-n)ièmes bits des différentes suites seront lues à l'extérieur de la deuxième boucle dans l'étape de mise à jour de la première boucle.

Le processeur possède une architecture dite de type "HARVARD", c'est à dire une architecture multi-bus parallèle. Il possède donc plusieurs bus de données permettant d'effectuer plusieurs transferts de données en parallèle.

On considère dans le cas présent que le processeur possède au moins deux bus de données permettant le transfert en parallèle de deux données indépendantes.

L'invention s'applique également si le processeur possède un seul bus de données moyennant quelques modifications à la portée de l'homme de l'art. Le temps de traitement sera alors augmenté.

La commande de l'opérateur peut se faire par le bus d'adresse du processeur en prévoyant un décodage des informations présentes sur ce bus. Elle peut également se faire par le bus d'instruction du processeur, ce qui permet une plus grande souplesse. Quelle que soit la solution retenue on parlera d'un bus de commande du processeur qui permet de commander l'opérateur.

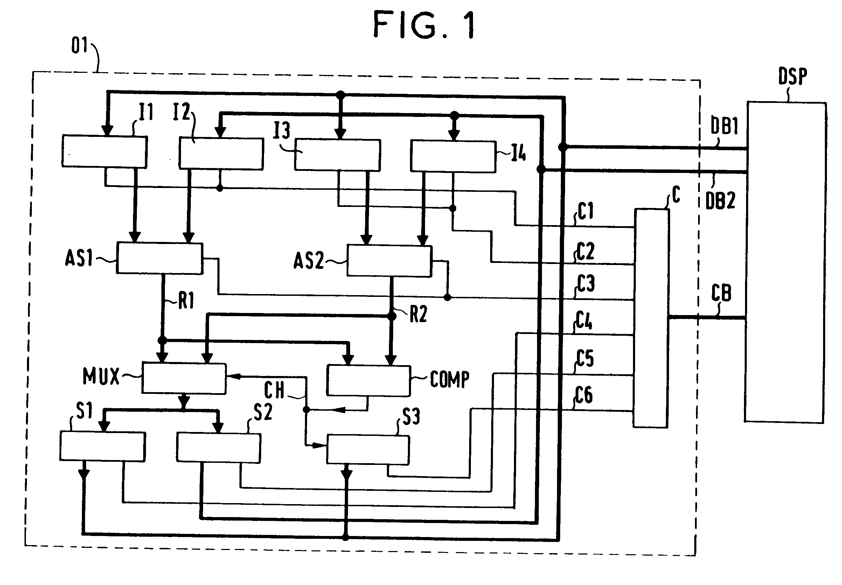

Le traitement de l'algorithme de Viterbi sera maintenant présenté à l'aide d'un circuit particulier représenté dans la figure 1. Ce circuit est donné à titre d'exemple et bien d'autres variantes sont possibles sans sortir du cadre de l'invention.

L'opérateur 01 est relié au processeur DSP par deux bus de données DB1, DB2 et un bus de commande CB. Il comprend quatre registres d'entrée, le premier I1 et le troisième I3 ayant leur entrées raccordées au premier bus de données DB1, le deuxième I2 et le quatrième I4 ayant leurs entrées raccordées au deuxième bus de données DB2. Il comprend un premier circuit de calcul AS1 produisant sur commande un premier résultat R1 de l'addition ou de la soustraction des données présentes dans les premier I1 et deuxième I2 registres d'entrée. Il comprend également un deuxième circuit de calcul AS2 produisant sur commande un second résultat R2 de l'addition ou de la soustraction des données présentes dans les troisièmes I3 et quatrième I4 registres d'entrée. L'opérateur 01 comprend de plus un comparateur COMP qui produit un signal de choix CH à l'état 1 lorsque le deuxième résultat R2 est supérieur au premier R1 et à l'état 0 dans le cas contraire. Il comprend aussi un multiplexeur MUX qui produit comme signal de sortie M le premier R1 ou le deuxième R2 résultat selon que le signal de choix vaut respectivement 0 ou 1. Il comprend trois registres de sortie, le premier S1 et le deuxième S2 recevant en entrée le signal de sortie M du multiplexeur, tandis que le troisième S3, du type registre à décalage mémorise les différentes valeurs prises successivement par le signal de choix CH. Les premier S1 et troisième S3 registres de sortie ont leur sortie raccordée au premier bus de données DB1, tandis que le deuxième registre de sortie S2 à sa sortie raccordée au deuxième bus de données DB2. Il comprend enfin un module de commande C qui produit les signaux de commande des différents éléments de l'opérateur en réponse aux informations présentes sur le bus de commande CB. Ces signaux sont :

- le premier signal de commande C1 à destination des premier I1 et deuxième I2 registres d'entrée,
- le deuxième signal de commande C2 à destination des troisième I3 et quatrième I4 registres d'entrée,
- le troisième signal de commande C3 pour positionner les deux circuits de calcul AS1, AS2 en mode addition ou soustraction,
- le quatrième signal de commande C4 à destination du premier registre de sortie S1,
- le cinquième signal de commande C5 à destination du deuxième registre de sortie S2,
- le sixième signal de commande C6 à destination du troisième registre de sortie S3.

Le module de commande C qui consistera généralement en un simple circuit de logique combinatoire ne sera pas détaillé car sa fonction apparaîtra clairement à l'homme de métier au vu de la succession des opérations effectuées par le dispositif décrite ci-après.

Le traitement de l'algorithme de Viterbi présenté plus haut peut maintenant être complété en précisant le rôle de l'opérateur et du processeur.

Boucle 2 :

- Calcul de la valeur de $P_r$ (b(i) = 0/$E_{2j}$) par le processeur DSP,
- Calcul de la valeur de $P_r$(b(i)=0/$E_{2j+1}$) par le processeur,
- Transfert de la valeur de $Met_{i-1}$ ($E_{2j}$) et de la valeur de $Pr(b(i)=0/E_{2j})$ du processeur vers l'opérateur 01,
- Transfert de la valeur de $Met_{i-1}$ ($E_{2j+1}$) et de la valeur de $Pr(b(i)=0/E_{2j+1})$ du processeur vers l'opérateur 01,
- calcul de $Met_i(E_j)$, calcul et stockage du (i-n)ième bit CH de la jème suite par l'opérateur,
- calcul de $Met_i(E_{j+a})$, calcul et stockage du (i-n)ième bit CH de la (j+a)ième suite par l'opérateur,
- transfert de la valeur de $Met_i(E_j)$ et de la valeur de $Met_i(E_{j+a})$ de l'opérateur au processeur.
  Fin boucle 2.
- Transfert des $2^n$ valeurs de (i-n)ièmes bits des suites de l'opérateur au processeur.

Il faut optimiser le nombre de cycles d'instruction pris par la deuxième boucle pour effectuer les opérations décrites ci-dessus. Il est délicat d'effectuer une estimation exacte de ce nombre de cycles car il dépend du type du processeur couplé à l'opérateur et de l'application de l'algorithme de Viterbi qui est envisagée. Néanmoins, on fera les hypothèses suivantes :

- Le calcul des probabilités conditionnelles ne prend qu'un seul cycle d'instruction du processeur et est effectué à l'intérieur de la deuxième boucle,
- Le processeur peut effectuer une opération et deux transferts de données en un seul cycle d'instruction.

Dans ce cas, les 7 étapes de la deuxième boucle se font en 5 cycles d'instructions du processeur en effectuant des traitements en parallèle entre l'opérateur et le processeur, ce que l'homme de l'art a pour pratique d'appeler "pipe-line". Ces deux organes travaillent simultanément pour deux valeurs consécutives de j : $j_o$ et $j_o+1$, en relation avec les deux états correspondants de l'algorithme $E_{2jo}$, $E_{2jo+2}$.

Pendant le premier cycle, le processeur DSP transfère la valeur de $Met_{i-1}$ ($E_{2jo}$) et la valeur de $Pr(b(i)=0/E_{2jo})$, valeurs calculées précédemment, respectivement par les bus de données DB1, DB2 respectivement aux premier I1 et deuxième I2 registres d'entrée au moyen du premier signal de commande C1.

Pendant le deuxième cycle, le processeur DSP transfère la valeur de $Met_{i-1}$ ($E_{2jo+1}$) et la valeur de $Pr(b(i)=O/E_{2jo+1})$, valeurs calculées précédemment, respectivement par les bus de données DB1, DB2, respectivement aux troisième I3 et quatrième I4 registres d'entrée au moyen du deuxième signal de commande.

Pendant le troisième cycle, le processeur DSP calcule la valeur de $Pr$ (b(i)=0/$E_{2jo+2}$), tandis que l'opérateur 01 calcule la valeur de $Met_i(E_{jo})$ en positionnant les deux circuits de calcul AS1, AS2 en mode addition au moyen du troisième signal de commande C3, mémorise cette valeur dans le premier registre de sortie $S_1$ au moyen de quatrième signal de commande C4, et mémorise le (i-n)ième bit correspondant CH dans le troisième registre de sortie S3 au moyen du sixième signal de commande C6.

Pendant le quatrième cycle, le processeur DSP calcule la valeur de $Pr(b(i)=0/E_{2jo+3})$, tandis que l'opérateur 01 calcule la valeur de $Met_i(E_{jo+a})$ en mode soustraction au moyen du troisième signal de commande C3, mémorise cette valeur dans le deuxième registre de sortie S2 au moyen du cinquième signal de commande C5, et mémorise le (i-n)ième bit correspondant CH dans le troisième registre de sortie S3 au moyen du sixième signal de commande C6.

Pendant le cinquième cycle, le processeur DSP fait l'acquisition des valeurs de $Met_i(E_{jo})$ et de $Met_i(E_{jo+a})$ par les deux bus de données DB1, DB2.

A la suite des $2^{n-1}$ itérations de la deuxième boucle, l'opérateur 01 transfère les différentes valeurs des (i-n)ièmes bits au processeur DSP par le premier bus de données DB1 au moyen du sixième signal de commande C6.

Il apparaît qu'il est nécessaire de prévoir une initialisation supplémentaire des valeurs des probabilités conditionnelles pour jo=0. Cette étape ne présente pas de difficulté pour l'homme du métier.

Il est également implicite que l'opérateur puisse effectuer les traitements prévus dans le troisième et quatrième cycle dans une durée compatible avec celle de ces cycles.

On voit donc que le nombre total N1 de cycles pour effectuer les deux boucles imbriquées si l'on note E1 le nombre de cycles externes à la deuxième boucle compris dans la première boucle, vaut :

$$N1 = (L - n)(2^{n-1}.5 + E1)$$

Si l'on note N2 le nombre total de cycles nécessaires dans le cas d'un processeur de traitement de signal unique effectuant le calcul d'une seule métrique maximale à partir de deux métriques au rang inférieur, et en notant E2 le nombre de cycles externes à la deuxième boucle compris dans la première boucle, ce nombre vaut :

$$N2 = (L - n).(2^n.8 + E2)$$

E1 et E2 étant couramment inférieur à dix, et n étant généralement compris entre 4 et 7, il s'ensuit que N1 est sensiblement trois fois plus petit que N2.

Dans un deuxième mode de réalisation de l'invention, l'opérateur effectue toutes les opérations de la deuxième boucle, c'est-à-dire qu'outre les opérations présentées dans le mode de réalisation précédent, il effectue les calculs de probabilités conditionnelles.

L'opérateur reçoit en entrée pour chaque itération de la deuxième boucle :

Pond (BT(I)) pour I = i.T,i.T+1,...,i.T+T-1

$Met_{i-1}(E_{2j})$

$Met_{i-1}(E_{2j+1})$

L'opérateur fournit en sortie pour chaque itération de la deuxième boucle :

$Met_i(E_j)$

$Met_i(E_{j+a})$

L'opérateur fournit en sortie pour chaque itération de la première boucle :

ch(i,j) pour j=0 à $2^{n-1}$

On considère, comme précédemment, que l'on initialise j à 0 à l'extérieur de la deuxième boucle dans l'étape d'initialisation de la première boucle, la valeur de j s'incrémentant automatiquement à chaque itération de la boucle. De plus, l'opérateur n'a pas besoin d'avoir les pondérations des bits transmis à chaque itération de la deuxième boucle, une seule fois suffisant. On considère donc que l'on transfère ces valeurs à l'opérateur à l'extérieur de la deuxième boucle mais dans la première boucle, à l'initialisation des valeurs.

Comme précédemment, on considère que les valeurs des (i-n)ièmes bits des différents suites seront lues à l'extérieur de la deuxième boucle dans la première boucle à l'étape de mise à jour.

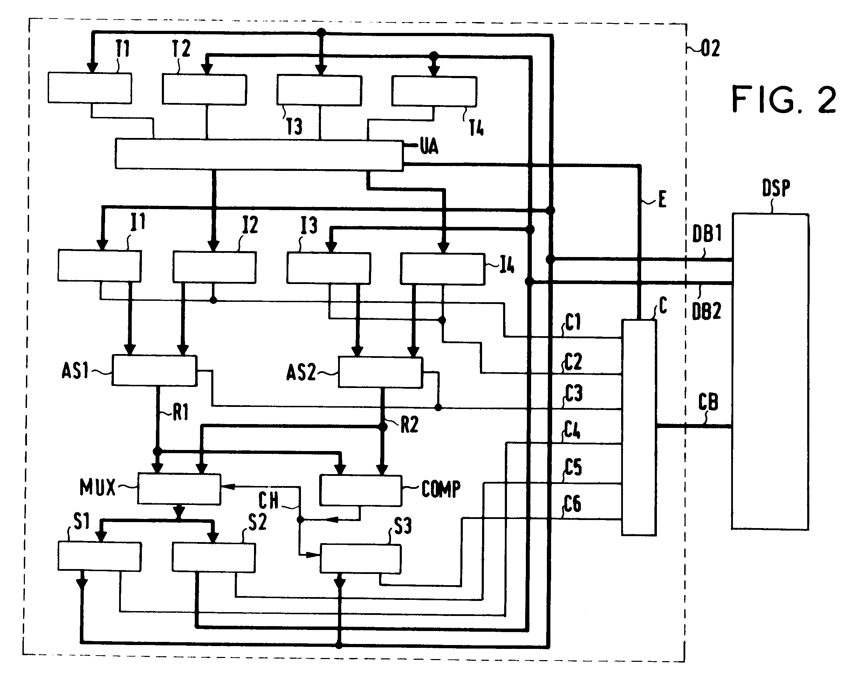

Le traitement de l'algorithme de Viterbi sera maintenant présenté à l'aide d'un autre circuit représenté dans la figure 2, le processeur étant identique à celui employé dans le premier mode de réalisation.

Dans l'exemple choisi, T est fixé égal à 4, ce qui permet de clarifier la description. Il ne faut pas voir là une restriction de l'invention qui s'applique quelle que soit la valeur de T moyennant quelques modifications mineures à la portée de l'homme du métier.

L'opérateur 02 se distingue de celui 01 décrit précédemment par les éléments suivants. Il comprend quatre registres de transfert, le premier T1 et le troisième T3 ayant leurs entrées raccordées au premier bus de données DB1, le deuxième T2 et le quatrième T4 ayant leurs entrées raccordées au deuxième bus de données DB2. Il comprend également une unité arithmétique UA qui calcule les expressions des probabilités conditionnelles à partir des signaux de sortie des quatre registres de transfert prévus pour mémoriser Pond (BT(i.4)), Pond (BT(i.4+1)), Pond (BT(i.4+2)) et Pond (BT(i.4+3)).

Cette unité arithmétique est un circuit câblé qui ne pose pas de difficultés de réalisation.

Le deuxième registre d'entrée I2 reçoit la valeur de $Pr(b(i=0/E_{2j})$ non plus par le deuxième bus de données DB2, mais directement de l'unité arithmétique UA. De même, le quatrième registre d'entrée I4 reçoit désormais la valeur de $Pr(b(i)=0/E_{2j+1})$ directement de l'unité arithmétique UA.

On prévoit de plus des signaux de commande additionnels pour la commande des registres de transfert et de l'unité arithmétique. Ces signaux ayant une fonction analogue à celle décrite dans le premier mode de réalisation, ils ne seront pas plus détaillés et ne sont pas représentés dans la figure. On prévoit également un signal d'état E qui transmet la valeur de j correspondant au nombre d'itérations de la deuxième boucle du module de commande C à l'unité arithmétique UA.

Le traitement de l'algorithme de Viterbi présenté plus haut peut maintenant être complété en précisant le rôle de l'opérateur et du processeur.

Boucle 1 : pour i=n+1 à L faire

- initialisation comprenant le transfert de Pond (Bt(i.4)), Pond (BT(i.4+1), Pond (BT(i.4+2) et Pond (BT(i.4+3 )) du processeur DSP aux quatre registres de transfert T1,T2, T3,T4.
- Boucle 2 : pour j=o à $2^{n-1}-1$ faire
- calcul de la valeur de $Pr(b)(i)=0/E_{2j})$ par l'opérateur 02,
- calcul de la valeur $Pr(b(i)=0/E_{2j+1})$ par l'opérateur 02,
- Transfert de $Met_{i-1}(E_{2j})$ du processeur DSP à l'opérateur,
- Transfert de $Met_{i-1}(E_{2j+1})$ du processeur DSP à l'opérateur,
- Calcul de $Met_i(E_j)$, calcul et stockage du (i-n)ième bit de la jième suite par l'opérateur,
- Calcul de $Met_i(Ej+a)$, calcul et stockage du (i-n)ième de la (j+a)ième suite par l'opérateur,
- Transfert des valeurs de $Met_i(Ej)$ et de $Met_i(Ej+a)$ de l'opérateur au processeur,
  Fin boucle 2.
- Transfert des $2^n$ valeurs des (i-n)ième bits des différentes suites de l'opérateur au processeur et mise à jour.
  Fin boucle 1.

On fera les mêmes hypothèses que dans le mode de réalisation précédent :
- Le calcul des probabilités conditionnelles ne prendrait qu'un seul cycle d'instruction du processeur DSP si il était effectué dans celui-ci,
- Le processeur DSP peut effectuer une opération et deux transferts de données en un seul cycle d'instruction.

Dans ce cas, les 7 étapes de la deuxième boucle se font en 2 cycles d'instructions du processeur en effectuant des traitements en parallèle entre le processeur et l'opérateur.

Ces deux organes travaillent simultanément pour deux valeurs consécutives de j : $j_o$ et $j_o+1$, en relation avec les deux états correspondants de l'algorithme $E_{2jo},E_{2jo+2}$.

Pendant le premier cycle, le processeur DSP transfère la valeur de $Met_{i-1}(E_{2jo+2})$ et la valeur de $Met_{i-1}(E_{2jo+3})$ respectivement au premier I1 et troisième I3 registres d'entrée, tandis que l'opérateur 02 calcule les valeurs de $Met_i(E_{jo})$ et de $Met_i(E_{jo+a})$, les mémorise et enregistre les (i-n)ièmes bits correspondants CH comme dans le mode de réalisation précédent.

Pendant le deuxième cycle, le processeur DSP fait l'acquisition des valeurs de $Met_i(E_{jo})$ et de $Met(E_{jo+a})$, tandis que l'opérateur 02 calcule les valeurs de $Pr(B(i)=0/E_{2jo+2})$ et de $Pr(b(i)=0/E_{2jo+3})$ dans l'unité arithmétique UA pour les fournir respectivement aux deuxième I2 et quatrième I4 registres d'entrée.

A la suite des $2^{n-1}$ itérations de la deuxième boucle, l'opérateur 02 transfère les différentes valeurs des (i-n)ièmes bits au processeur DSP.

Il apparaît qu'il est nécessaire de prévoir une initialisation supplémentaires des valeurs des probabilités conditionnelles pour jo=0. Cette étape ne présente pas de difficulté pour l'homme de métier.

Il est également implicite que l'opérateur puisse effectuer les traitements prévus dans les deux cycles d'instruction chacun dans une durée compatible avec celle d'un cycle.

On voit donc que le nombre total N3 de cycles pour effectuer les deux boucles imbriquées, si l'on note E3 le nombre de cycles externes à la deuxième boucle compris dans la première boucle, vaut :

$$N3 = (L - n).(2^{n-1}.2 + E3)$$

Si l'on note N4 le nombre total de cycles nécessaires dans le cas d'un processeur de traitement de signal unique effectuant le calcul d'une seule métrique maximale à partir de deux métriques au rang inférieur, et en notant E4 le nombre de cycles externes à la deuxième boucle compris dans la première boucle, ce nombre vaut :

$$N4 = (L - n). (2^n.8 + E4)$$

On peut considérer que E3 est un peu supérieur à E4 mais ces deux valeurs sont petites par rapport à $2^n$. Les ordres de grandeur donnés dans le cadre du premier mode de réalisation restant valables, il s'ensuit que N3 est sensiblement huit fois plus petit que N4.

Ainsi, des deux modes de réalisation présentés, le second possède des meilleurs performances en terme de vitesse de traitement mais il nécessite une unité arithmétique cablée pour effectuer le calcul des expressions des probabilités conditionnelles. Sa mise en oeuvre dépend du contexte de transmission et n'est donc pas très souple. En effet, si on veut que le même opérateur puisse permettre plusieurs utilisations de l'algorithme de VITERBI, il faut alors que celui-ci possède plusieurs unités arithmétiques, chacune d'elles permettant de calculer les expressions des probabilités conditionnelles associées à une utilisation de l'algorithme. Ceci entraîne donc une augmentation de la taille de l'opérateur.

Par contre, le premier permet différentes utilisations de l'algorithme, ceci sans modification. En effet, d'une utilisation à l'autre, la seule chose qui change dans l'algorithme est la définition des expressions des probabilités conditionnelles qui sont calculés par le processeur.

Ces deux modes de réalisation possèdent des performances différentes pour un coût différent et le choix de l'un ou de l'autre se fait suivant les spécifications souhaitées.

Les opérateurs de l'invention peuvent être réalisées de deux façons différentes, soit totalement externe au processeur auquel ils sont couplés, soit partiellement inclus dans ce processeur.

Dans le premier cas, l'opérateur est indépendant du processeur.

Dans le deuxième cas, on peut remplacer certains registres de l'opérateur par les registres contenus dans l'unité arithmétique et logique des données du processeur. La surface prise par l'opérateur est donc réduite en conséquence.

Le premier cas s'applique que l'opérateur et le processeur soient où ne soient pas dans un même composant tandis que le second cas ne peut s'envisager que dans une solution où l'on intègre le processeur et l'opérateur dans un même composant.

L'invention étant décrite dans sa structure, certaines applications dans le domaine de la transmission en seront maintenant présentées.

Les deux utilisations les plus courantes de l'algorithme de Viterbi en traitement numérique du signal sont le décodage de codes convolutionnel et l'égalisation en démodulation de signaux affectés d'interférence intersymbole.

Dans le cadre du décodage d'un code convolutionnel, pour traiter l'algorithme de Viterbi il faut :
- les pondérations des probabilités de valeur des bits de la suite transmise,
- la relation traduisant l'opération de transmission.

Usuellement, en traitement du signal, le décodage se fait après la démodulation. C'est le démodulateur qui fournit les pondérations. La relation traduisant l'opération de transmission est le codage convolutionnel. Ce codage relie un bit codé BC à (n+1) bits b de la suite initiale au moyen des relations suivantes :

$$BC(T.k) = b(k) \oplus a_{11} \cdot b(k-1) \oplus , \ldots, \oplus a_{n1} \cdot b(k-n)$$

$$BC(T.k+1) = b(k) \oplus a_{12} \cdot b(k-1) \oplus , \ldots, \oplus a_{n2} \cdot b(k-n)$$

$$\ldots \ldots \ldots \ldots \ldots \ldots \ldots \ldots \ldots \ldots \ldots \ldots \ldots \ldots \ldots \ldots \ldots \ldots \ldots$$

$$BC(T.k+T-1) = b(k) \oplus a_{1T} \cdot b(k-1) \oplus , \ldots, \oplus a_{nT} \cdot b(k-n)$$

où :

$\oplus$ représente un "ou exclusif" logique

$k = 1, \ldots, L$; L étant égal au nombre de bits de la suite initiale

$a_{ij} = 0$ ou 1 suivant le codage choisi.

On connaît les pondérations Pond $(BT(i) = B(i)), i = 1, \ldots, T.L$, qui correspondent aux probabilités de valeur des bits transmis. En effectuant une inversion de variable entre b(i) et BC(T.i), en remplaçant dans l'expression précédente les bits codés BC(I) par les pondérations correspondantes Pond (BT(I)), et en normalisant les expressions, on obtient les T expressions suivantes :

$$Pr_1 (b(k)=X/n) = Pond (BT(T.k)) \cdot N[X \oplus a_{11} \cdot b(k-1) \oplus , \ldots, \oplus a_{n1} \cdot b(k-n)]$$

$$Pr_2 (b(k)=X/n) = Pond (BT(T.k+1)) \cdot N[X \oplus a_{12} \cdot b(k-1) \oplus , \ldots, \oplus a_{n2} \cdot b(k-n)]$$

$$\ldots \ldots \ldots \ldots \ldots \ldots \ldots \ldots \ldots \ldots \ldots \ldots \ldots \ldots \ldots \ldots \ldots \ldots \ldots$$

$$PrT(b(k)=X/n = Pond (BT(T.k+T-1) \cdot N[X \oplus a_{1T} \cdot b(k-1) \oplus , \ldots, \oplus a_{nT} \cdot b(k-n)]$$

où :

X est un symbole binaire

N [bit] : fonction normalisante définie par :

N [bit] = 1 si bit = 1, = -1 si bit = 0.

Ces T expressions correspondent donc aux probabilités conditionnelles du bit b(k) d'être égal à X connaissant la valeur des n bits antécédents. On regroupe tous ces termes en un seul pour avoir une expression correspondant à la probabilité conditionnelle totale :

$$Pr(b(k)=X/E_j) = \sum_{i=1}^{T} Pr_i(b(k)=X/n)$$

où $E_j$ est l'état défini par les n bits antécédents.

Cette expression définit donc l'expression de la probabilité conditionnelle totale correspondant à celle utilisée dans l'invention.

Dans le cadre de l'égalisation en démodulation de signaux affectés d'interférence intersymbole, pour traiter l'algorithme de Viterbi il faut :
- les pondérations des probabilités de valeur des bits de la suite transmise,
- la relation traduisant l'opération de transmission.

Usuellement, en traitement du signal, l'égalisation se fait après le filtrage adapté à la réponse impulsionnelle du canal transmission. C'est le filtre adapté qui fournit les pondérations.

La relation traduisant l'opération de transmission est celle qui caractérise un signal numérique modulé dans un canal affecté d'interférence intersymbole. Cette relation n'introduit pas de redondance (T=1) et relie chaque bit à transmettre aux n bits précédents de la suite initiale.

Cette relation s'exprime directement par la formulation suivante qui définit une expression de la probabilité conditionnelle de valeur du ième bit de la suite initiale connaissant ses n antécédents qui définissent l'état $E_j$ et la pondération du ième bit transmis :

$$Pr(b(i)=0/E_j) = -Pond(BT(i)) + \sum_{k=1}^{n-1} U(i-k).S(k)$$

où

U(k) = 2.b(k)-1,

S(k) = kième coefficient d'interférence intersymbole.

Le deuxième opérande du membre de droite de l'égalité correspond à ce que l'on peut définir comme terme d'interférence des n bits antécédents au bit b(i). En effet, les termes U(i-k) (pour k=1 à n-1) représentent les n bits antécédents au bit b(i), et les termes S(k) sont les coefficients d'interférence intersymbole associés aux bits antécédents b(i-k).

Ces coefficients d'interférence intersymbole sont constants durant la transmission d'une suite de L bits. Ils engendrent $2^n$ termes d'interférence correspondant aux $2^n$ états $E_j$ possibles. On calcule donc ces $2^n$ termes à l'extérieur de la première bouche. Le calcul d'une probabilité conditionnelle se réduit alors à l'addition d'une pondération et d'un terme d'interférence.

## Revendications

1. Dispositif prévu pour le traitement de l'algorithme de Viterbi comprenant un processeur (DSP), cet algorithme étant défini par sa longueur de contrainte de valeur n+1 et ses $2^n$ états associés à des suites de bits, le traitement ayant pour objet l'estimation d'une suite initiale de bits b(i), à partir d'une suite transmise résultant d'une opération de transmission effectuée sur ladite suite initiale, caractérisé en ce qu'il comprend un opérateur (01, 02) pour établir la métrique maximale au rang r de l'état $E_j$ dénommée $Met_r(E_j)$, pour r supérieur à n, et le (r-n)ième bit de la suite correspondant à cette métrique (CH), à partir de valeurs d'entrées que sont les métriques maximales au rang r-1 des états $E_{2k}$ et $E_{2k+1}$ notées $Met_{r-1}(E_{2k})$ et $Met_{r-1}(E_{2k+1})$, et les probabilités conditionnelles en rapport auxdits états $E_{2k}$, $E_{2k+1}$ que le rième bit des suites associées à ces états ait une valeur déterminée représentées par $Pr(b(r)=0/E_{2k})$ et $Pr(b(r)=0/E_{2k+1})$, k étant égal à 2j pour tout j inférieur à $2^{n-1}$ et valant $2(j-2^{n-1})$ pour tout j supérieur ou égal à $2^{n-1}$, de sorte que $Met_r(E_j)$ prenne la valeur de la plus grande des deux expressions suivantes, la première étant $Met_{r-1}(E_{2k})+Pr(b(r)=0/E_{2k})$ et la seconde étant $Met_{r-1}(E_{2k+1}) + Pr(b(r)=0/E_{2k+1})$.

2. Dispositif prévu pour le traitement de l'algorithme de Viterbi comprenant un processeur (DSP) selon la revendication 1, caractérisé en ce que ledit opérateur (01, 02) comprend des moyens additionnels (AS1, AS2, S2) pour établir quel que soit j inférieur à $2^{n-1}$ à partir desdites valeurs d'entrée non seulement la métrique maximale au rang r de l'état $E_j$ $\mathrm{Met}_r(E_j)$ et le (r-n)ième bit correspondant (CH), mais également la métrique maximale au rang r de l'état $E_{j+a}$ $\mathrm{Met}_r(E_{j+a})$ et le (r-n)ième bit correspondant où a vaut $2^{n-1}$, de sorte que $\mathrm{Met}_r(E_{j+a})$ prenne la valeur de la plus grande des deux formules suivantes, la première étant $\mathrm{Met}_{r-1}(E_{2j})$ - $\mathrm{Pr}(b(r)=0/E_{2j})$ et la seconde étant $\mathrm{Met}_{r-1}(E_{2j+1})$ - $\mathrm{Pr}(b(r)=0/E_{2j+1})$.

3. Dispositif prévu pour le traitement de l'algorithme de Viterbi comprenant un processeur (DSP) selon la revendication 2, caractérisé en ce que, ledit opérateur (01) étant relié audit processeur (DSP) par au moins un bus de données (DB1, DB2) et un bus de commande (CB), il (01) comprend quatre registres d'entrée (I1, I2, I3, I4) dont les entrées respectives sont connectées chacune à l'un quelconque desdits bus de données, le premier (I1) étant prévu pour recevoir la valeur de $\mathrm{Met}_{r-1}(E_{2j})$, le second (I2) la valeur de $\mathrm{Pr}(b(i)=0/E_{2j})$, le troisième (I3) la valeur de $\mathrm{Met}_{r-1}(E_{2j+1})$ et le quatrième (I4) la valeur de $\mathrm{Pr}(b(i)=0/E_{2j+1})$, il comprend également un premier (AS1) et un deuxième (AS2) circuits de calcul prévus pour produire respectivement un premier (R1) et un deuxième (R2) résultats prenant la valeur en réponse à un signal de commande (C3) de la somme ou de la différence des contenus respectivement des deux premiers registres d'entrées (I1, I2) et des deux derniers registres d'entrée (I3, I4), il comprend un comparateur (COMP) délivrant un signal de sortie (CH) de valeur 1 lorsque ledit premier résultat (R1) est inférieur audit deuxième résultat (R2) et de valeur 0 dans le cas contraire, un multiplexeur (MUX) commandé par ledit comparateur (COMP) produisant comme signal de sortie (M) celui desdits résultats (R1, R2) qui présente la plus forte valeur, il comprend de plus trois registres de sortie (S1, S2, S3) dont les sorties respectives sont raccordées chacune à l'un quelconque desdits bus de données (DB1, DB2), le premier (S1) et le deuxième (S2) recevant le signal de sortie (M) dudit multiplexeur (MUX) et étant prévus pour enregistrer les valeurs de respectivement $\mathrm{Met}_r(E_j)$ et $\mathrm{Met}_r(E_{j+a})$, le troisième (S3) recevant le signal de sortie (CH) dudit comparateur (COMP) qui est le (r-n)ième bit des suites correspondant à ces métriques, et il comprend un module de commande (C) prévu pour commander ses différents éléments en fonction des informations adressées par ledit processeur (DSP) sur ledit bus de commande (CB).

4. Dispositif prévu pour le traitement de l'algorithme de Viterbi comprenant un processeur (DSP) selon la revendication 3, caractérisé en ce que ledit troisième registre de sortie (S3) est de plus prévu pour enregistrer le (r-n)ième bit de toutes les suites correspondant aux $2^n$ métriques maximales à un rang déterminé.

5. Dispositif prévu pour le traitement de l'algorithme de Viterbi comprenant un processeur (DSP), selon la revendication 3 ou 4 caractérisé en ce que, ledit processeur (DSP) comprenant deux bus de données (DB1, DB2), lesdits premier (I1) et troisième (I3) registres d'entrée ont leur entrée connectée au premier (DB1) desdits bus de données, lesdits deuxième (I2) et quatrième (I4) registres d'entrée ont leur entrée connectée au second (DB2) desdits bus de données, tandis que lesdits premier (S1) et second (S2) registres de sortie ont leurs sorties connectées chacune à un bus de donnée distinct (DB1, DB2).

6. Dispositif prévu pour le traitement de l'algorithme de Viterbi comprenant un processeur (DSP), selon la revendication 2 caractérisé en ce que ledit opérateur (02) comprend des moyens supplémentaires (UA) pour établir lesdites probabilités conditionnelles en rapport aux états $E_{2k}$, $E_{2k+1}$ que les rièmes bits des suites associées à ces états aient un état déterminé en fonction des pondérations des bits de ladite suite transmise liés auxdits rièmes bits, du nombre k associé auxdits états $E_{2k}$, $E_{2k+1}$ et des relations définissant ladite opération de transmission.

7. Dispositif prévu pour le traitement de l'algorithme de Viterbi comprenant un processeur (DSP), selon la revendication 6 caractérisé en ce que, ledit opérateur (02) étant relié audit processeur (DSP) par au moins un bus de données (DB1, DB2) et un bus de commande (CB), il (02) comprend des registres de transfert (T1, T2, T3, T4) dont les entrées respectives sont reliées chacune à l'un quelconque desdits bus de données (DB1, DB2), ces registres de transfert (T1, T2, T3, T4) étant prévus pour mémoriser chacun une desdites pondérations, et une unité arithmétique cablée (UA) connectée aux sorties desdits registres de transfert, quant accès à la valeur j identifiant un état, et établissant les relations définissant ladite opération de transmission pour produire lesdites probabilités conditionnelles, il comprend quatre registres d'entrée (I1, I2, I3, I4), le premier (I1) dont l'entrée est raccordée à l'un quelconque desdits bus de données (DB1, DB2) étant prévu pour recevoir la valeur de $\mathrm{Met}_{r-1}(E_{2j})$, le second (I2) mémorisant la valeur de $\mathrm{Pr}(b(r)=0/E_{2j})$ fournie par ladite unité arithmétique (UA), le troisième (I3) dont l'entrée est raccordée à l'un quelconque desdits bus de données (DB1, DB2) étant prévu pour recevoir la valeur de $\mathrm{Met}_{r-1}(E_{2j+1})$ et le quatrième (I4) mémorisant la valeur de $\mathrm{Pr}(b(r)=0/E_{2j+1})$ fournie par ladite unité arithmétique (UA), il comprend également un premier (AS1) et un deuxième (AS2) circuits de calcul prévus pour produire respectivement un premier (R1) et un deuxième (R2) résultats prenant la valeur en réponse à un signal de commande (C3) de la somme ou de la différence des contenus respectivement des deux premiers registres d'entrée (I1, I2) et des deux derniers registres d'entrée (I3, I4), il comprend un comparateur (COMP) délivrant un signal de sortie (CH) de valeur 1 lorsque ledit premier résultat (R1) est inférieur audit deuxième résultat et de valeur 0 dans le cas contraire, et un multiplexeur (MUX) commandé par ledit comparateur (COMP) produisant comme signal de sortie (M) celui desdits résultats (R1, R2) qui présente la plus forte valeur, il comprend de plus trois registres de sortie (S1, S2, S3) dont les sorties respectives sont raccordées chacune à l'un quelconque desdits bus de données (DB1, DB2), le premier (S1) et le deuxième (S2) recevant le signal de sortie (M) dudit multiplexeur (MUX) et étant prévus pour enregistrer les valeurs de respectivement $Met_r(E_j)$ et $Met_r(E_{j+a})$, le troisième (S3) recevant le signal de sortie (CH) dudit comparateur (COMP) qui est le (r-n)ième bit des suites correspondant à ces métriques, et il comprend un module de commande prévu pour commander ses différentes éléments en fonction des informations adressées par ledit processeur (DSP) sur ledit bus de commande (CB).

8. Dispositif prévu pour le traitement de l'algorithme de Viterbi comprenant un processeur (DSP), selon la revendication 7, caractérisé en ce que ledit troisième registre de sortie (S3) est de plus prévu pour enregistrer le(r-n)ième bit de toutes les suites correspondant aux $2^n$ métriques maximales à un rang déterminé.

9. Dispositif prévu pour le traitement de l'algorithme de Viterbi comprenant un processeur (DSP), selon la revendication 7 ou 8 caractérisé en ce que, ledit processeur (DSP) comprenant deux bus de données (DB1, DB2), lesdits registres de transfert (T1, T2, T3, T4) ont leurs entrées réparties sur le premier (DB1) et sur le second (DB2) desdits bus de données (DB1, DB2), le premier (I1) et le troisième (I3) desdits registres d'entrées ont leurs entrées reliées chacune à un bus de données distinct, tandis que lesdits premier (S1) et second (S2) registres de sortie ont leurs sorties connectées chacune à un bus de données distinct.

10. Dispositif prévu pour le traitement de l'algorithme de Viterbi comprenant un processeur (DSP) selon l'une quelconque des revendications précédentes, caractérisé en ce que un élément au moins dudit opérateur (01, 02) est implanté dans ledit processeur (DSP).

11. Application du dispositif pour le traitement de l'algorithme de Viterbi comprenant un processeur (DSP) selon l'une quelconque des revendications précédentes caractérisée en ce que, ladite opération de transmission étant un codage convolutionnel, elle permet le décodage de ladite suite transmise.

12. Application du dispositif prévu pour le traitement de l'algorithme de Viterbi comprenant un processeur (DSP), selon l'une quelconque des revendications 1 à 10 caractérisée en ce que, ladite opération de transmission introduisant une interférence intersymbole dans ladite suite transmise, elle permet l'égalisation de cette suite.

## Patentansprüche

1. Vorrichtung zur Verarbeitung des Viterbi-Algorithmus mit einem Prozessor (DSP), wobei dieser Algorithmus durch seine Zwangslänge des Werts n+1 und $2^n$ Zustände definiert ist, die Folgen von Bits zu geordnet sind, wobei die Verarbeitung auf die Schätzung einer ursprünglichen Folge von Bits b(i) ausgehend von einer übertragenen Folge abzielt, die aus einer Übertragungsoperation resultiert, der die ursprüngliche Folge ausgesetzt war, dadurch gekennzeichnet, daß die Vorrichtung einen Operator (01, 02) aufweist, um die maximale Metrik des Rangs r des Zustands $E_j$, $Met_r(E_j)$ genannt, zu erzeugen, wobei r > n gilt und das (r-n)-te Bit der Folge dieser Metrik (CH) entspricht, wobei diese Metrik ausgehend von Eingangswerten erzeugt wird, die die maximalen Metriken des Rangs r-1 der Zustände $E_{2k}$ und $E_{2k+1}$, $Met_{r-1}(E_{2k})$ und $Met_{r-1}(E_{2k+1})$ genannt, und die konditionalen Wahrscheinlichkeiten $Pr(b(r)=0/E_{2k})$ bzw. $Pr(b(r)=0/E_{2k+1})$ bezüglich der Zustände $E_{2k}$ und $E_{2k+1}$ sind, daß das r-te Bit der diesen Zuständen zugeordneten Folgen einen bestimmten Wert hat, wobei k = 2j für jedes j unter $2^{n-1}$ und k = 2(j-$2^{n-1}$) für jedes j größer oder gleich $2^{n-1}$ gilt, derart, daß $Met_r(E_j)$ den Wert des größeren der beiden nachfolgenden Ausdrücke annimmt, von denen der erste $Met_{r-1}(E_{2k})+Pr(b(i)=0/E_{2k})$ und der zweite $Met_{r-1}(E_{2k})+Pr(b(i)=0/E_{2k+1})$ ist.

2. Vorrichtung für die Verarbeitung des Viterbi-Algorithmus mit einem Prozessor (DSP) gemäß Anspruch 1, dadurch gekennzeichnet, daß der Operator (01, 02) zusätzliche Mittel (AS1, AS2, S2) besitzt, um für jedes beliebige j unter $2^{n-1}$ ausgehend von den Eingangswerten nicht nur die maximale Metrik des Rangs r des

Zustands $E_j$, nämlich $Met_r(E_j)$, und das (r-n)-te entsprechende Bit (CH), sondern auch die maximale Metrik des Rangs r des Zustands $E_{j+a}$, nämlich $Met_r(E_{j+a})$, und das (r-n)-te entsprechende Bit zu erzeugen, wobei $a = 2^{n-1}$ gilt, derart, daß $Met_r(E_{j+a})$ den Wert des größeren der beiden nachfolgenden Ausdrücke annimmt, von denen der erste $Met_{r-1}(E_{2j})-Pr(b(r) =0/E_{2j})$ und der zweite $Met_{r-1}(E_{2j+1})-Pr(b(r) =0/E_{2j+1})$ ist.

3. Vorrichtung für die Verarbeitung des Viterbi-Algorithmus mit einem Prozessor (DSP) nach Anspruch 2, dadurch gekennzeichnet, daß der Operator (01) mit dem Prozessor (DSP) über mindestens einen Datenbus (DB1, DB2) und einen Steuerbus (CB) verbunden ist und vier Eingangsregister (I1, I2, I3, I4) besitzt, deren jeweilige Eingänge an eine der Datenbusleitungen angeschlossen sind, wobei das erste Eingangsregister (I1) zum Empfang des Wertes $Met_{r-1}(E_{2j})$ , das zweite (I2) zum Empfang des Wertes von $Pr(b(i)=0/E_{2j})$, das dritte (I3) zum Empfang des Wertes von $Met_{r-1}(E_{2j+1})$ und das vierte Eingangsregister (I4) zum Empfang des Wertes von $Pr(b(i)=0/E_{2j+1})$ vorgesehen ist, wobei weiter ein erster (AS1) und ein zweiter Rechenkreis (AS2) vorgesehen sind, um ein erstes (R1) bzw. zweites Ergebnis (R2) zu erzeugen, das aufgrund eines Steuersignals (C3) die Summe oder die Differenz der in den beiden ersten Eingangsregistern (I1, I2) bzw. der beiden letzten Eingangsregister (I3, I4) enthaltenen Werte annimmt, wobei ein Komparator (COMP) vorgesehen ist, der ein Ausgangssignal (CH) des Werts 1 liefert, wenn das erste Ergebnis (R1) kleiner als das zweite Ergebnis (R2) ist, und im übrigen den Wert 0, wobei ein Multiplexer (MUX), der von dem Komparator (COMP) gesteuert wird, als Ausgangssignal (M) dasjenige der Ergebnisse (R1, R2) erzeugt, das den größeren Wert besitzt, wobei weiter drei Ausgangsregister (S1, S2, S3) vorgesehen sind, deren Ausgänge je an eine der Datenbusleitungen (DB1, DB2) angeschlossen sind, wobei das erste und das zweite Ausgangsregister (S1, S2) das Ausgangssignal (M) des Multiplexers (MUX) empfangen und zur Speicherung der Werte von $Met_r(E_j)$ bzw. $Met_r(E_{j+a})$ bestimmt sind, während das dritte Ausgangsregister das Ausgangssignal (CH) des Komparators (COMP) empfingt, das das (r-n)-te Bit der diesen Metriken entsprechenden Folgen ist, und wobei ein Steuermodul (C) vorgesehen ist, um die verschiedenen Elemente abhängig von Informationen zu steuern, die vom Prozessor (DSP) auf dem Befehlsbus (CB) adressiert werden.

4. Vorrichtung zur Verarbeitung des Viterbi-Algorithmus mit einem Prozessor (DSP) gemäß Anspruch 3, dadurch gekennzeichnet, daß das dritte Ausgangsregister (S3) außerdem zur Speicherung des (r-n)-ten Bits aller Folgen entsprechend den $2^n$ maximalen Metriken eines bestimmten Rangs vorgesehen ist.

5. Vorrichtung für die Verarbeitung des Viterbi-Algorithmus mit einem Prozessor (DSP) gemäß Anspruch 3 oder 4, dadurch gekennzeichnet, daß bei einem Prozessor (DSP) mit zwei Datenbusleitungen (DB1, DB2) das erste und dritte Eingangsregister (I1, I3) mit ihrem Eingang an den ersten Datenbus (DB1) angeschlossen sind, während das zweite und das vierte Eingangsregister (I2, I4) mit ihrem Eingang an den zweiten Datenbus (DB2) angeschlossen sind, wobei das erste (S1) und das zweite Ausgangsregister mit ihren Ausgängen je an einen anderen Datenbus (DB1, DB2) angeschlossen sind.

6. Vorrichtung für die Verarbeitung des Viterbi-Algorithmus mit einem Prozessor (DSP) gemäß Anspruch 2, dadurch gekennzeichnet, daß der Operator (02) zusätzliche Mittel (UA) enthält, um die konditionalen Wahrscheinlichkeiten bezüglich der Zustände $E_{2k}$, $E_{2k+1}$ zu erzeugen, daß die r-ten Bits der diesen Zuständen zugewiesenen Folgen einen bestimmten Zustand abhängig von den Wichtungen der Bits in der übertragenen Folge, die mit diesen r-ten Bits verknüpft sind, von der diesen Zuständen $E_{2k}$ und $E_{2k-1}$ zugeordneten Zahl k und von den Beziehungen besitzen, die die Übertragungsoperation definieren.

7. Vorrichtung für die Verarbeitung des Viterbi-Algorithmus mit einem Prozessor (DSP) nach Anspruch 6, dadurch gekennzeichnet, daß der Operator (02), der mit dem Prozessor (DSP) über mindestens einen Datenbus (DB1, DB2) und einen Befehlsbus (CB) verbunden ist, Übertragungsregister (T1, T2, T3, T4) aufweist, deren Eingänge je an eine beliebige der Datenbusleitungen (DB1, DB2) angeschlossen sind, wobei diese Übertragungsregister (T1, T2, T3, T4) zur Speicherung je einer der Wichtungen vorgesehen sind, wobei weiter eine verdrahtete arithmetische Einheit (UA) vorgesehen ist, die an die Ausgänge der Übertragungsregister angeschlossen ist, zum Wert j, der einen Zustand identifiziert, Zugriff hat und die Beziehungen erzeugt, die die Übertragungsoperation definieren, um die konditionalen Wahrscheinlichkeiten zu erzeugen, wobei der Operator (02) weiter vier Eingangsregister (I1, I2, I3, I4) besitzt, von denen das erste (I1), dessen Eingang an eine beliebige der Datenbusleitungen (DB1, DB2) angeschlossen ist, zum Empfang des Wertes von $Met_{r-1}(E_{2j})$, das zweite (I2) zur Speicherung des Werts von $Pr(b(r)=0/E_{2j})$, der von der arithmetischen Einheit (UA) geliefert wird, das dritte (I3), dessen Eingang an eine beliebige der Datenbusleitungen (DB1, DB2) angeschlossen ist, zum Empfang des Wertes von $Met_{r-1}(E_{2j+1})$ be-

stimmt ist und das vierte (I4) den Wert von Pr(b(r)=0/E$_{2j+1}$) speichert, das von der arithmetischen Einheit (UA) geliefert wird, wobei weiter erste (AS1) und zweite Rechenkreise (AS2) vorgesehen sind, um ein erstes (R1) bzw. zweites Ergebnis (R2) zu erzeugen, das abhängig von einem Steuersignal (C3) die Summe oder die Differenz der in den beiden ersten Eingangsregistern (I1, I2) bzw. den beiden letzten Eingangsregistern (I3, I4) enthaltenen Werte liefert, wobei weiter ein Komparator (COMP) vorgesehen ist, der ein Ausgangssignal (CH) des Werts 1 liefert, wenn das erste Ergebnis (R1) kleiner als das zweite Ergebnis (R2) ist, und im übrigen den Wert 0, wobei ein Multiplexer (MUX), der von dem Komparator (COMP) gesteuert wird, als Ausgangssignal (M) dasjenige der Ergebnisse (R1, R2) erzeugt, das den größeren Wert besitzt, wobei weiter drei Ausgangsregister (S1, S2, S3) vorgesehen sind, deren Ausgänge je an irgendeine der Datenbusleitungen (DB1, DB2) angeschlossen sind, wobei das erste und das zweite Ausgangsregister (S1, S2) das Ausgangssignal (M) des Multiplexers (MUX) empfangen und zur Speicherung der Werte von Met$_r$(E$_j$) bzw. Met$_r$(E$_{j+a}$) bestimmt sind, während das dritte Ausgangsregister (S3) das Ausgangssignal (CH) des Komparators (COMP) empfängt, das das (r-n)-te Bit der diesen Metriken entsprechenden Folgen ist, und wobei ein Steuermodul vorgesehen ist, um die verschiedenen Elemente abhängig von Informationen zu steuern, die vom Prozessor (DSP) auf dem Befehlsbus (CB) adressiert werden.

8. Vorrichtung für die Verarbeitung des Viterbi-Algorithmus mit einem Prozessor (DSP) nach Anspruch 7, dadurch gekennzeichnet, daß das dritte Ausgangsregister (S3) außerdem zur Speicherung des (r-n)-ten Bits aller Folgen entsprechend den $2^n$ maximalen Metriken eines bestimmten Rangs vorgesehen ist.

9. Vorrichtung zur Verarbeitung des Viterbi-Algorithmus mit einem Prozessor (DSP) nach Anspruch 7 oder 8, dadurch gekennzeichnet, daß bei einem Prozessor (DSP), der zwei Datenbusleitungen (DB1, DB2) besitzt, die Übertragungsregister (T1, T2, T3, T4) mit ihren Eingängen auf den ersten (DB1) und den zweiten Datenbus (DB2) verteilt sind, wobei das erste (I1) und das dritte Eingangsregister (I3) mit ihren Eingängen je an einen anderen Datenbus angeschlossen sind, während die Ausgange des ersten (S1) und zweiten Ausgangsregisters (S2) je an einen eigenen Datenbus angeschlossen sind.

10. Vorrichtung zur Bearbeitung des Viterbi-Algorithmus mit einem Prozessor (DSP) nach einem beliebigen der vorhergehenden Ansprüche, dadurch gekennzeichnet, daß mindestens ein Element des Operators (01, 02) in den Prozessor (DSP) eingebaut ist.

11. Anwendung der Vorrichtung zur Verarbeitung des Viterbi-Algorithmus mit einem Prozessor (DSP) nach einem beliebigen der vorhergehenden Ansprüche, dadurch gekennzeichnet, daß die Übertragungsoperation eine Konvolutionskodierung ist und die Vorrichtung die Dekodierung der übertragenen Folge erlaubt.

12. Anwendung der Vorrichtung zur Verarbeitung des Viterbi-Algorithmus mit einem Prozessor (DSP) nach einem beliebigen der Ansprüche 1 bis 10, dadurch gekennzeichnet, daß die Übertragungsoperation eine Interferenz zwischen den Symbolen in der übertragene Folge herbeiführt und daß die Vorrichtung die Egalisierung dieser Folge erlaubt.


## Claims

1. Device for processing the Viterbi algorithm comprising a processor (DSP), said algorithm being defined by its constraint length of value n+1 and its $2^n$ states associated with streams of bits, the object of the processing being to estimate an original bit stream b(i) produced from a transmitted bit stream resulting from a transmission operation effected on said original bit stream, characterized in that it comprises an operator (01, 02) to establish the maximal metric of rank r of the state E$_j$, denoted Met$_r$(E$_j$), for r greater than n and the (r-n)th bit of the bit stream corresponding to said metric (CH) from input values which are the maximal metrics of rank r-1 of states E$_{2k}$ and E$_{2k+1}$ denoted Met$_{r-1}$(E$_{2k}$) and Met$_{r-1}$(E$_{2k+1}$), and to establish the conditional probabilities denoted Pr(b(r)=0/E$_{2k}$) and Pr(b(r)=0/E$_{2k+1}$) related to said states E$_{2k}$ and E$_{2k+1}$ that the rth bit of the bit streams associated with these states has a predetermined value, where k is equal to 2j for any value of j less than $2^{n-1}$ and has the value 2(j-$2^{n-1}$) for any value of j greater than or equal to $2^{n-1}$ so that Met$_r$(E$_j$) takes the larger of the values of the expressions Met$_{r-1}$(E$_{2k}$)+ Pr(b(i)=0/E$_{2k}$) and Met$_{r-1}$(E$_{2k}$)+Pr(b(i)= 0/E$_{2k+1}$).

2. Device for processing the Viterbi algorithm comprising a processor (DSP) according to claim 1, characterized in that said operator (01, 02) comprises additional means (AS1, AS2, S2) for establishing for any value of j less than $2^{n-1}$ from said input values not only the maximal metric of rank r of the state $E_j$ $Met_r(E_j)$ and the (r-n)th corresponding bit (CH) but also the maximal metric of rank r of the state $E_{j+a}$, $Met_r(E_{j+a})$, and the (r-n)th corresponding bit where a has the value $2^{n-1}$, so that $Met_r(E_{j+a})$ takes the larger of the values of the formulae $Met_{r-1}(E_{2j})-Pr(b(i)=0/E_{2j})$ and $Met_{r-1}(E_{2j})-Pr(b(i)=0/E_{2j+1})$.

3.  Device for processing the Viterbi algorithm comprising a processor (DSP) according to claim 2, characterized in that said operator (01) being connected to said processor (DSP) by at least one data bus (DB1, DB2) and a control bus (CB), said operator (01) comprises four input registers (I1, I2, I3, I4) whose inputs are each connected to one of said data buses, the first (I1) being adapted to receive the value of $Met_{r-1}$ $(E_{2j})$, the second (I2) the value of $Pr(b(i)=0/E_{2j})$, the third (I3) the value of $Met_{r-1}(E_{2j+1})$ and the fourth (I4) the value of $Pr(b(i)=0/E_{2j+1})$, first and second calculator circuits (AS1, AS2) adapted respectively to produce first and second results (R1, R2) taking the value in response to a control signal (C3), of the sum or the difference of the respective contents of the first two input registers (I1, I2) and the last two input registers (I3, I4), a comparator (COMP) delivering an output signal (CH) of value 1 when said first result (R1) is less than said second result (R2) and of value 0 otherwise, a multiplexer (MUX) controlled by said comparator (COMP) producing as output signal (M) that of said registers (S1, S2, S3) whose outputs are each connected to one of said data buses (DB1, DB2), the first (S1) and the second (S2) receiving the output signal (M) of said multiplexer (MUX) and being adapted to store the respective values of $Met_r(E_j)$ and $Met_r(E_j+a)$, the third (S3) receiving the output signal (CH) of said comparator (COMP) which is the (r-n)th bit of the bit streams corresponding to these metrics, and a control module (C) adapted to control its various units according to information addressed by said processor (DSP) on said control bus (CB).

4.  Device for processing the Viterbi algorithm comprising a processor (DSP) according to claim 3, characterized in that said third output register (S3) is also adapted to store the (r-n)th bit of all the bit streams corresponding to the $2^n$ maximal metrics of a given rank.

5.  Device for processing the Viterbi algorithm comprising a processor (DSP), according to claim 3 or claim 4, characterized in that, said processor comprising two data buses, said first (I1) and third (I3) input registers have their input connected to the first data bus (DB1), said second and fourth input registers (I2, I4) have their input connected to the second data bus (DB2) and said first and second output registers (S1, S2) have their outputs each connected to a separate data bus (DB1, DB2).

6.  Device for processing the Viterbi algorithm comprising a processor (DSP) according to claim 2, characterized in that said operator (02) comprises additional means (UA) for establishing said conditional probabilities related to the states $E_{2k}$, $E_{2k+1}$ that the rth bits of the bit streams associated with these states have a given state according to the weightings of the bits of said bit stream transmitted related to said rth bits, to the number k associated with said states $E_{2k}$, $E_{2k+1}$ and to the relationships defining said transmission operation.

7.  Device for processing the Viterbi algorithm comprising a processor (DSP) according to claim 6, characterized in that said operator (02) being connected to said processor (DSP) by at least one data bus (DB1, DB2) and a control bus (CB), said operator (02) comprises four input registers (I1, I2, I3, I4) whose inputs are each connected to one of said data buses (DB1, DB2), these transfer registers being each adapted to store one of said weightings, and a hardwired arithmetic unit (UA) connected to the outputs of said transfer registers having access to the value j identifying a state and establishing the relationships defining said transmission operation to produce said conditional probabilities, four input registers (I1, I2, I3, I4) of which the first (I1) has its input connected to one of said data buses (DB1, DB2) and is adapted to receive the value of $Met_{r-1}(E_{2j})$, of which the second (I2) stores the value of $Pr(b(i)=0/E_{2j})$ supplied by said arithmetic unit (UA), of which the third (I3) whose input is connected to one of said data buses (DB1, DB2) is adapted to receive the value of $Met_{r-1}(E_{2j+1})$ and of which the fourth (I4) stores the value of $Pr(b(r)=0/E_{2j+1})$ supplied by said arithmetic unit (UA), first and second calculator circuits (AS1, AS2) adapted respectively to produce first and second results (R1, R2) taking the value in response to a control signal (C3) of the sum or the difference of the respective contents of the first two input registers (I1, I2) and the last two input registers (I3, I4), a comparator (COMP) supplying an output signal (CH) of value 1 when said first result (R1) is less than said second result (R2) and of value 0 otherwise, a multiplexer (MUX) controlled by said comparator (COMP) producing as output signal (M) that of said results (R1, R2) which has the greater value, three output registers (S1, S2, S3) whose outputs are each connected to one of said data buses (DB1, DB2), the first (S1) and the second (S2) receiving the output signal (M) of said multiplexer (MUX) and being adapted to store the respective values of $Met_r(E_j)$ and $Met_r(E_{j+a})$, the third (S3) receiving the output signal (CH) of said comparator (COMP) which is the (r-n)th bit of the bit streams corresponding to these metrics, and a control module adapted to control its various units according to information addressed by said processor (DSP) on said control bus (CB).

8. Device for processing the Viterbi algorithm comprising a processor (DSP) according to claim 7, characterized in that said third output register (S3) is also adapted to store the (r-n)th bit of all the bit streams corresponding to the $2^n$ maximal metrics of a given rank.

9. Device for processing the Viterbi algorithm comprising a processor (DSP) according to claim 7 or claim 8, characterized in that, said processor (DSP) comprising two data buses (DB1, DB2), said transfer registers (T1, T2, T3, T4) have their inputs distributed among the first and second data buses (DB1, DB2), the first and the third input registers (I1, I3) having their inputs each connected to a separate data bus and said first and second output registers (S1, S2) having their outputs each connected to a separate data bus.

10. Device for processing the Viterbi algorithm comprising a processor (DSP) according to any one of the preceding claims, characterized in that at least one element of said operator is incorporated in said processor (DSP).

11. Application of the device for processing the Viterbi algorithm comprising a processor (DSP) according to any one of the preceding claims, characterized in that, said transmission operation being convolutional encoding, it enables decoding of said transmitted bit stream.

12. Application of the device for processing the Viterbi algorithm comprising a processor (DSP) according to any one of claims 1 through 10, characterized in that, said transmission operation introducing intersymbol interference into said transmitted bit stream, it enables equalization of said bit stream.

# FIG. 1

EP 0 485 921 B1

FIG. 2

EP 0 485 921 B1